# FASCICULE DE BREVET EUROPEEN

(11) **EP 3 458 951 B1**
(45) Date de publication et mention de la délivrance du brevet: **12.08.2020**
(21) Numéro de dépôt: 17723425.9
(22) Date de dépôt: 18.05.2017
(51) Int. Cl.: G06F 7/58

(54) **DISPOSITIF DE GÉNÉRATION D'UN SIGNAL ÉLECTRIQUE ALÉATOIRE ET ARCHITECTURE ASSOCIÉE**
VORRICHTUNG ZUR ERZEUGUNG EINES ELEKTRISCHEN ZUFALLSSIGNALS UND ZUGEHÖRIGE ARCHITEKTUR
DEVICE FOR GENERATING A RANDOM ELECTRICAL SIGNAL AND ASSOCIATED ARCHITECTURE

(30) Priorité: 18.05.2016 FR 1600791
(43) Date de publication de la demande: 27.03.2019
(73) Titulaire: Thales, 92400 Courbevoie (FR); Centre National de la Recherche Scientifique, 75016 Paris (FR)
(72) Inventeur: PINNA, Daniele, 00199 Roma (IT); GROLLIER, Julie, 75013 Paris (FR); CROS, Vincent, 75011 Paris (FR); QUERLIOZ, Damien, 94110 Arcueil (FR); BESSIERE, Pierre, 75013 Paris (FR); DROULEZ, Jacques, 75004 Paris (FR)
(74) Mandataire: Lavoix
(86) Numéro de dépôt international: PCT/EP2017/061941
(87) Numéro de publication internationale: WO 2017/198758

(56) Documents cités:
- WO-A1-2015/015007
- Anonymous: "Artificial magnetic monopoles discovered", , 31 mai 2013 (2013-05-31), XP055336087, Extrait de l'Internet: URL:https://phys.org/news/2013-05-artifici al-magnetic-monopoles.html [extrait le 2017-01-17]
- KIRAKOSYAN A S ET AL: "From Bubble to Skyrmion: Dynamic Transformation Mediated by a Strong Magnetic Tip", ARXIV.ORG, CORNELL UNIVERSITY LIBRARY, 201 OLIN LIBRARY CORNELL UNIVERSITY ITHACA, NY 14853, 21 mai 2003 (2003-05-21), XP080116951, DOI: 10.1016/J.JMMM.2006.01.113
- JUNICHI IWASAKI ET AL: "Current-induced skyrmion dynamics in constricted geometries", NATURE NANOTECHNOLOGY, vol. 8, no. 10, 8 septembre 2013 (2013-09-08), pages 742-747, XP055119148, ISSN: 1748-3387, DOI: 10.1038/nnano.2013.176
- CHUI C P ET AL: "Skyrmion stability in nanocontact spin-transfer oscillators", AIP ADVANCES, AMERICAN INSTITUTE OF PHYSICS, 2 HUNTINGTON QUADRANGLE, MELVILLE, NY 11747, vol. 5, no. 9, 1 janvier 1901 (1901-01-01) , XP012200245, DOI: 10.1063/1.4930904
- FINOCCHIO G ET AL: "Skyrmion based microwave detectors and harvesting", APPLIED PHYSICS LETTERS, A I P PUBLISHING LLC, US, vol. 107, no. 26, 28 décembre 2015 (2015-12-28), XP012204087, ISSN: 0003-6951, DOI: 10.1063/1.4938539 [extrait le 1901-01-01]
- DAX M. CRUM ET AL: "Perpendicular reading of single confined magnetic skyrmions", NATURE COMMUNICATIONS, vol. 6, 1 juillet 2015 (2015-07-01), page 8541, XP055336074, DOI: 10.1038/ncomms9541

## Description

La présente invention concerne un dispositif de génération d'un signal électrique aléatoire. La présente invention se rapporte aussi à une architecture comprenant un tel dispositif.

L'invention se situe dans le domaine de l'informatique stochastique.

L'informatique stochastique est une approche qui traite simultanément un problème important dans les systèmes semi-conducteurs et de nombreux systèmes nano-électroniques. De fait, comme la taille des entités dans les puces informatiques est réduite, le comportement idéal ne peut pas toujours être garanti. Dans de tels systèmes, les résultats d'opérations individuelles ne sont décrits que de manière statistique ou probabiliste.

L'informatique stochastique cherche à traiter d'éléments de calcul probabilistes plutôt que de concevoir des manières de les rendre idéaux ou déterministes. Des recherches récentes suggèrent que les systèmes naturels biologiques sont de nature probabiliste.

De manière plus précise, l'informatique stochastique englobe un ensemble de techniques qui représentent les valeurs par des flux de bits aléatoires. La valeur codée dans le flux de bits correspond à la fraction de bits observés dans l'état «1».

L'informatique stochastique permet ainsi d'effectuer des calculs plus complexes sur ces valeurs que les opérations effectuées bit par bit. Par exemple, la multiplication sur deux flux de bits peut être effectuée simplement en utilisant une porte « ET ». Comme les deux flux d'entrée sont gérés par la porte, le flux de sortie fournit une estimation approximative très rapide du résultat. Cette estimation est de plus en plus précise à mesure que les flux d'entrée sont étendus. En outre, les opérations proposées dans le cadre de l'informatique stochastique sont robustes contre le bruit. De fait, le basculement accidentel de quelques bits dans le flux n'a pas un impact sur le résultat final de la multiplication.

Ainsi, il est souhaitable de disposer d'outils permettant de mettre en oeuvre l'informatique stochastique.

Puisque tous les calculs sont effectués par des portes opérant sur les flux de bits aléatoires, la décorrélation statistique des flux binaires utilisés est primordiale pour assurer un faible taux d'erreur.

Cependant, la mise en cascade des portes pour effectuer des opérations complexes conduit à favoriser la corrélation des signaux, ce qui rend crucial la mise en œuvre technique de « reshuffler » stochastique, c'est-à-dire de dispositif capable de convertir un signal d'entrée aléatoire en un signal de sortie aléatoire et décorrélé.

Toutefois, les systèmes permettant une telle conversion sont des systèmes reposant sur des filtres de décorrélation comme décrit dans les demandes WO 2009/045649, US 2013/0166307, US 2014/0185811. Ce sont donc des systèmes encombrants avec des dimensions usuellement supérieures à 4000 µm².

Il existe donc un besoin pour un dispositif capable de convertir un signal d'entrée aléatoire en un signal de sortie aléatoire et décorrélé présentant une taille plus réduite que dans les systèmes utilisant des filtres de décorrélation.

A cet effet, il est décrit un dispositif de génération d'un signal électrique aléatoire, le dispositif comprenant au moins un conduit d'entrée, au moins un conduit de sortie, un générateur de particules magnétiques propre à générer des particules magnétiques dans le conduit d'entrée, une chambre de diffusion reliée à au moins un conduit d'entrée et à au moins un conduit de sortie, la chambre de diffusion étant propre à diffuser les particules magnétiques générées, une unité de déplacement des particules magnétiques générées vers la chambre de diffusion, et un convertisseur adapté à générer un signal électrique proportionnel à une caractéristique relative aux particules magnétiques, la caractéristique étant la densité de particules magnétiques dans la chambre de diffusion ou le passage de particules magnétiques à un endroit prédéterminé d'un conduit de sortie relié à la chambre de diffusion.

Suivant des modes particuliers de réalisation, le dispositif comporte l'une ou plusieurs des caractéristiques suivantes, prises individuellement ou suivant toutes les combinaisons techniquement possibles :
- le générateur de particules magnétiques est propre à générer des skyrmions.
- une unité de commande comportant une borne d'introduction d'un signal aléatoire d'entrée, l'unité de commande étant propre à commander le générateur de particules magnétiques en fonction du signal aléatoire d'entrée.
- l'unité de commande est propre à commander le générateur de particules magnétiques pour générer une particule magnétique en présence d'une transition prédéterminée entre deux états prédéfinis.
- un thermostat propre à contrôler la température de la chambre de diffusion.
- au moins l'un de la géométrie et de l'agencement des conduits reliés à la chambre de diffusion est choisi pour maximiser la probabilité que les particules magnétiques subissent une diffusion.
- la chambre de diffusion comporte un obturateur propre à obturer chaque conduit de sortie.

Il est également proposé une architecture de génération d'un signal électrique aléatoire comportant une pluralité de dispositifs tels que précédemment décrits, une unité de commande comportant une borne d'introduction d'un signal aléatoire d'entrée, l'unité de commande étant propre à commander chaque générateur de particules magnétiques en fonction du signal aléatoire d'entrée.

Suivant des modes particuliers de réalisation, l'architecture comporte l'une ou plusieurs des caractéristiques suivantes, prises individuellement ou suivant toutes les combinaisons techniquement possibles :
- le signal aléatoire d'entrée se décompose en un nombre d'états prédéfinis et en transitions entre ces états, l'unité de commande étant propre à commander chaque générateur de particules magnétiques en fonction des états et des transitions.
- l'architecture comporte deux dispositifs, un premier dispositif et un deuxième dispositif, le signal aléatoire d'entrée se décomposant en transitions entre deux états dits état bas et état haut, une transition haute étant une transition depuis l'état bas vers l'état haut et une transition basse étant une transition depuis l'état haut vers l'état bas, l'unité de commande étant propre à commander le premier générateur de particules magnétiques pour générer une particule magnétique en présence d'une transition haute et l'unité de commande étant propre à commander le deuxième générateur de particules magnétiques pour générer une particule magnétique en présence d'une transition basse.

D'autres caractéristiques et avantages de l'invention apparaîtront à la lecture de la description qui va suivre, donnée uniquement à titre d'exemple et faite en se référant aux dessins annexés, qui sont :
- figure 1, une vue schématique d'un exemple de dispositif de génération d'un signal électrique aléatoire,
- figure 2, une vue schématique d'une partie d'un autre exemple de dispositif de génération d'un signal électrique aléatoire,
- figure 3, une vue schématique d'une partie d'encore un autre exemple de dispositif de génération d'un signal électrique aléatoire,
- figure 4, une vue schématique d'une partie d'encore un autre exemple de dispositif de génération d'un signal électrique aléatoire, et
- figure 5, une vue schématique d'un exemple d'architecture.

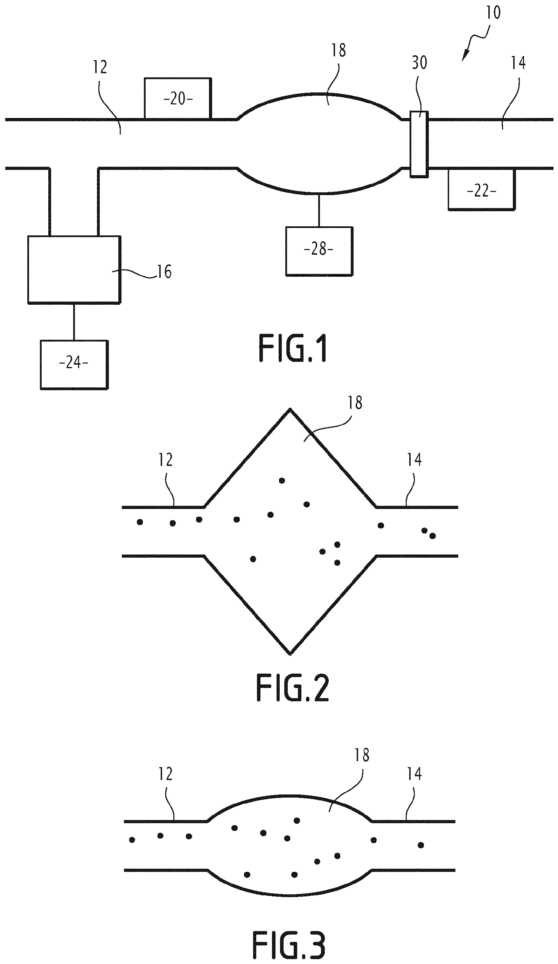

La figure 1 illustre un dispositif 10.

Le dispositif 10 est un dispositif de génération d'un signal électrique aléatoire.

De préférence, le dispositif 10 est un dispositif propre à générer un signal électrique aléatoire par conversion d'un signal aléatoire d'entrée, le signal de sortie étant décorrélé du signal d'entrée.

Le dispositif 10 comprend un conduit d'entrée 12, un conduit de sortie 14, un générateur 16, une chambre de diffusion 18, une unité de déplacement 20, un convertisseur 22, une unité de commande 24 et un thermostat 28.

Le conduit d'entrée 12 se présente sous la forme d'un conduit.

Le conduit d'entrée 12 débouche dans la chambre de diffusion 18.

Le conduit de sortie 14 se présente sous la forme d'un conduit.

La chambre de diffusion 18 débouche dans le conduit de sortie 14.

Selon l'exemple de la figure 1, le conduit d'entrée 12 et le conduit de sortie 14 sont diamétralement opposés.

Le générateur 16 est un générateur de particules magnétiques.

Le générateur 16 est propre à générer des particules magnétiques dans le conduit d'entrée 12.

Selon l'exemple illustré, le générateur 16 est propre à générer des skyrmions.

Le générateur 16 est, par exemple, une jonction tunnel magnétique.

La chambre de diffusion 18 est propre à diffuser les particules magnétiques générées.

Dans l'exemple illustré, la chambre de diffusion 18 présente une forme sphérique.

La chambre de diffusion 18 relie le conduit d'entrée 12 au conduit de sortie 14.

La chambre de diffusion 18 comporte un obturateur 30 propre à obturer le conduit de sortie 14.

L'unité de déplacement 20 est propre à déplacer des particules magnétiques générées vers la chambre de diffusion 18.

Par simplification, l'unité de déplacement 20 a été représentée sur la figure 1 sous forme d'un bloc indépendant. Toutefois, usuellement, l'unité de déplacement 20 est, en pratique, une couche magnétique sur laquelle circule un courant électrique, de sorte que vue de haut, l'unité de déplacement 20 est située en-dessous de la chambre de diffusion 18, du conduit d'entrée 12 et du conduit de sortie 14.

Le convertisseur 22 est adapté à générer un signal électrique proportionnel à une caractéristique relative aux particules magnétiques.

Selon un exemple particulier, le convertisseur 22 est une jonction tunnel magnétique.

Selon le mode de réalisation de la figure 1, la caractéristique est le passage de particules magnétiques à un endroit prédéterminé du conduit de sortie 14.

L'unité de commande 24 comporte une borne d'introduction d'un signal aléatoire d'entrée.

L'unité de commande 24 est propre à commander le générateur 16 en fonction du signal aléatoire d'entrée.

Selon l'exemple illustré, l'unité de commande 24 est propre à commander le générateur 16 pour générer une particule magnétique en présence d'une transition prédéterminée entre deux états prédéfinis.

Le thermostat 28 est propre à contrôler la température de la chambre de diffusion 18.

Le fonctionnement du dispositif 10 est maintenant décrit.

L'unité de commande 24 reçoit un signal aléatoire d'entrée.

Le signal aléatoire d'entrée comporte une transition entre un état bas et un état haut à un premier instant t1.

L'unité de commande 24 convertit le signal aléatoire d'entrée en commandant au générateur 16 de générer des skyrmions au premier instant t1.

Les skyrmions sont générés dans le conduit d'entrée 12.

L'unité de déplacement 20 déplace les skyrmions générés vers la chambre de diffusion 18.

Les skyrmions subissent une diffusion dans la chambre de diffusion 18.

Dans un tel mode de réalisation, il est supposé que l'obturateur 30 n'obture pas le conduit de sortie 14.

Dans ce cas, le convertisseur 22 génère un signal électrique proportionnel à la détection d'un passage de skyrmions à un endroit prédéterminé du conduit de sortie 14.

A chaque passage de skyrmion, il est considéré que le signal électrique du convertisseur comporte une transition entre un état bas et un état haut au deuxième instant t2.

Par cet exemple de mise en oeuvre simple, il apparaît qu'un signal électrique aléatoire d'entrée est converti en un autre signal aléatoire de sortie. Cette conversion a lieu dans les deux cas illustrés.

De plus, comme des skyrmions sont utilisés, le dispositif 10 est de dimension réduite. De fait, la taille de la chambre de diffusion 18 est inférieure au micromètre carré.

De plus, l'énergie assurant le fonctionnement du dispositif 10 est très faible. Typiquement, pour un courant de quelques microampères, l'application d'une tension de quelques centaines de millivolts suffit. Le dispositif 10 est donc économe en énergie.

Plus généralement, le dispositif 10 convertit un signal aléatoire d'entrée en un autre signal aléatoire décorrélé en sortie.

Une telle conversion a lieu de manière exacte si le nombre de particules magnétiques est conservé pendant l'opération de diffusion. Lorsque le nombre de particules magnétiques n'est pas conservé, la conversion n'est qu'approximative.

Autrement dit, le dispositif 10 utilise la diffusion des particules due au bruit thermique pour décorréler le signal aléatoire d'entrée, ce qui, dans le cas idéal, implique une conservation des particules et un temps de diffusion suffisant. Le temps de diffusion dépend de plusieurs facteurs comme l'intensité du courant, la dimension des skyrmions et la dimension de la chambre de diffusion 18. Le temps de diffusion usuel est compris entre 1 microseconde et 1 milliseconde.

De ce fait, d'autres modes de réalisation du dispositif 10 sont envisageables. Certains de ces modes de réalisation sont décrits aux figures 2, 3 et 4.

Selon autre mode de réalisation, le convertisseur 22 est placé dans la chambre de diffusion 18.

Dans ce cas, la caractéristique est la densité de particules magnétiques dans la chambre de diffusion 18 et non le passage de particules magnétiques à un endroit prédéterminé du conduit de sortie 14.

Le fonctionnement du dispositif 10 dans ce mode de réalisation diffère un peu du fonctionnement précédemment présenté.

En effet, dans ce cas, il est supposé que l'obturateur 30 obture le conduit de sortie 14.

Dans ce cas, le convertisseur 22 génère un signal électrique proportionnel à la densité de skyrmions dans la chambre de diffusion 18.

Il est à noter que, dans ce premier cas, le dispositif 10 sert aussi de dispositif de mémorisation.

Selon un autre exemple, la forme de la chambre de diffusion 18 est différente.

La chambre de diffusion 18 a, par exemple, une forme en section polygonale. Selon l'exemple de la figure 2, la chambre de diffusion 18 présente une forme en section carrée.

Selon un autre exemple notamment illustré par la figure 3, la chambre de diffusion 18 présente une forme ellipsoïdale.

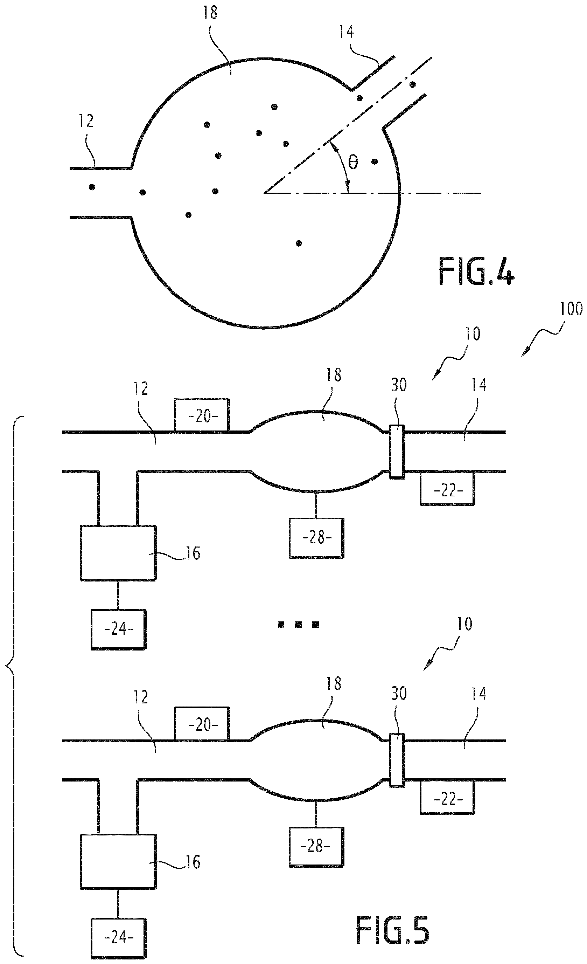

Selon encore un autre exemple, le conduit d'entrée 12 et le conduit de sortie 14 ne sont pas diamétralement opposés mais forment un angle noté θ sur la figure 4.

De manière générale, au moins l'un de la géométrie et de l'agencement des conduits reliés à la chambre est choisi pour maximiser la probabilité que les particules magnétiques subissent une diffusion dans la chambre de diffusion 18.

Il est également à noter que la géométrie idéale dépend de multiples facteurs dont la taille des particules.

En variante, le dispositif 10 comporte une pluralité de conduits, chacun relié à la chambre de diffusion 18.

Les conduits effectivement suivis par la particule magnétique étant a priori aléatoires, le signal de sortie est encore mieux décorrélé du signal aléatoire d'entrée.

En outre, en interprétant le signal électrique aléatoire comme une génération de nombre aléatoires, il est possible d'étendre le principe proposé avec le dispositif 10 de la figure 1 pour viser du fonctionnement multiniveaux permettant de générer tout nombre aléatoire.

Pour cela, en référence à la figure 5, il est proposé une architecture 100 comportant une pluralité de dispositifs 10. Seuls deux dispositifs 10 sont représentés sur la figure 5.

Dans ce cas, le signal aléatoire d'entrée se décompose en un nombre d'états prédéfinis et en transitions entre ces états et l'unité de commande 24 qui est réparti en plusieurs sous-unités (une sous-unité par dispositif 10) est propre à commander chaque générateur 16 de particules magnétiques en fonction des états et des transitions.

Le fonctionnement de l'architecture 100 est maintenant décrit en référence au cas où l'architecture 100 comporte deux dispositifs 10, l'extension à un nombre supérieur de dispositifs 10 étant immédiate.

Dans une telle hypothèse, le signal aléatoire d'entrée se décompose en transitions entre deux états dits état bas et état haut.

Une transition haute est une transition depuis l'état bas vers l'état haut et une transition basse est une transition depuis l'état haut vers l'état bas.

L'unité de commande 24 commande le premier générateur 16 de particules magnétiques pour générer une particule magnétique en présence d'une transition haute. Respectivement, l'unité de commande 24 commande le deuxième générateur 16 de particules magnétiques pour générer une particule magnétique en présence d'une transition basse.

En recombinant les signaux obtenus en sortie de chacun des dispositifs 10, il est obtenu un signal aléatoire de sortie décorrélé du signal aléatoire d'entrée et étant un signal à deux niveaux.

Les avantages du dispositif 10 s'appliquent donc pour l'architecture 100.

Le même principe s'appliquerait pour un nombre quelconque de niveaux.

## Revendications

1. Dispositif (10) de génération d'un signal électrique aléatoire, le dispositif (10) comprenant :
- au moins un conduit d'entrée (12),
- au moins un conduit de sortie (14),
- un générateur (16) de particules magnétiques propre à générer des particules magnétiques dans le conduit d'entrée (12),
- une chambre de diffusion (18) reliée à au moins un conduit d'entrée (12) et à au moins un conduit de sortie (14), la chambre de diffusion (18) étant propre à diffuser les particules magnétiques générées,
- une unité de déplacement (20) des particules magnétiques générées vers la chambre de diffusion (18),
et
- un convertisseur (22) adapté à générer un signal électrique proportionnel à une caractéristique relative aux particules magnétiques, la caractéristique étant la densité de particules magnétiques dans la chambre de diffusion (18) ou le passage de particules magnétiques à un endroit prédéterminé d'un conduit de sortie (14) relié à la chambre de diffusion (18).

2. Dispositif selon la revendication 1, dans lequel le générateur (16) de particules magnétiques est propre à générer des skyrmions.

3. Dispositif selon la revendication 1 ou 2, dans lequel le dispositif (10) comporte, en outre, une unité de commande (24) comportant une borne d'introduction d'un signal aléatoire d'entrée, l'unité de commande (24) étant propre à commander le générateur (16) de particules magnétiques en fonction du signal aléatoire d'entrée.

4. Dispositif selon la revendication 3, dans lequel l'unité de commande (24) est propre à commander le générateur (16) de particules magnétiques pour générer une particule magnétique en présence d'une transition prédéterminée entre deux états prédéfinis.

5. Dispositif selon l'une quelconque des revendications 1 à 4, dans lequel le dispositif (10) comporte, en outre, un thermostat (28) propre à contrôler la température de la chambre de diffusion (18).

6. Dispositif selon l'une quelconque des revendications 1 à 5, dans lequel au moins l'un de la géométrie et de l'agencement des conduits (12, 14) reliés à la chambre de diffusion (18) est choisi pour maximiser la probabilité que les particules magnétiques subissent une diffusion.

7. Dispositif selon l'une quelconque des revendications 1 à 6, dans lequel la chambre de diffusion (18) comporte un obturateur (30) propre à obturer chaque conduit de sortie (14).

8. Architecture (100) de génération d'un signal électrique aléatoire comportant :
- une pluralité de dispositifs (10) selon l'une quelconque des revendications 1 à 7,
- une unité de commande (24) comportant une borne d'introduction d'un signal aléatoire d'entrée, l'unité de commande (24) étant propre à commander chaque générateur (16) de particules magnétiques en fonction du signal aléatoire d'entrée.

9. Architecture selon la revendication 8, dans lequel le signal aléatoire d'entrée se décompose en un nombre d'états prédéfinis et en transitions entre ces états, l'unité de commande (24) étant propre à commander chaque générateur (16) de particules magnétiques en fonction des états et des transitions.

10. Architecture selon la revendication 8 ou 9, dans lequel l'architecture (100) comporte deux dispositifs (10), un premier dispositif (10) et un deuxième dispositif (10), le signal aléatoire d'entrée se décomposant en transitions entre deux états dits état bas et état haut, une transition haute étant une transition depuis l'état bas vers l'état haut et une transition basse étant une transition depuis l'état haut vers l'état bas, l'unité de commande (24) étant propre à commander le premier générateur (16) de particules magnétiques pour générer une particule magnétique en présence d'une transition haute et l'unité de commande (24) étant propre à commander le deuxième générateur (16) de particules magnétiques pour générer une particule magnétique en présence d'une transition basse.

## Patentansprüche

1. Vorrichtung (10) zur Erzeugung eines elektrischen Zufallssignals, wobei die Vorrichtung (10) umfasst:
- mindestens eine Eingangsleitung (12),
- mindestens eine Ausgangsleitung (14),
- einen Magnetpartikelerzeuger (16), der imstande ist, Magnetpartikel in der Eingangsleitung (12) zu erzeugen,
- eine Verteilerkammer (18), die mit mindestens einer Eingangsleitung (12) und mit mindestens einer Ausgangsleitung (14) verbunden ist, wobei die Verteilerkammer (18) imstande ist, die erzeugten Magnetpartikel zu verteilen,
- eine Verlagerungseinheit (20) der erzeugten Magnetpartikel zu der Verteilerkammer (18),
und
- einen Wandler (22), der zur Erzeugung eines elektrischen Signals geeignet ist, das proportional zu einer sich auf die Magnetpartikel beziehenden Eigenschaft ist, wobei die Eigenschaft die Magnetpartikeldichte in der Verteilerkammer (18) oder der Wechsel von Magnetpartikeln an eine vorher festgelegte Stelle einer mit der Verteilerkammer (18) verbundenen Ausgangsleitung (14) ist.

2. Vorrichtung nach Anspruch 1, wobei der Magnetpartikelerzeuger (16) imstande ist, Skyrmionen zu erzeugen.

3. Vorrichtung nach Anspruch 1 oder 2, wobei die Vorrichtung (10) ferner eine Steuereinheit (24) aufweist, die eine Klemme zwecks Einleitung eines zufallsbedingten Eingangssignals aufweist, wobei die Steuereinheit (24) imstande ist, den Magnetpartikelerzeuger (16) in Abhängigkeit von dem zufallsbedingten Eingangssignal zu steuern.

4. Vorrichtung nach Anspruch 3, wobei die Steuereinheit (24) imstande ist, den Magnetpartikelerzeuger (16) zu steuern, um ein Magnetpartikel bei Vorliegen eines vorher bestimmten Übergangs zwischen zwei vorher festgelegten Zuständen zu erzeugen.

5. Vorrichtung nach einem der Ansprüche 1 bis 4, wobei die Vorrichtung (10) ferner ein Thermostat (28) aufweist, das imstande ist, die Temperatur der Verteilerkammer (18) zu überwachen.

6. Vorrichtung nach einem der Ansprüche 1 bis 5, wobei mindestens eine von der Geometrie und der Anordnung der mit der Verteilerkammer (18) verbundenen Leitungen (12, 14) ausgewählt ist, um die Wahrscheinlichkeit zu maximieren, dass die Magnetpartikel einer Verteilung unterzogen werden.

7. Vorrichtung nach einem der Ansprüche 1 bis 6, wobei die Verteilerkammer (18) einen Verschluss (30) aufweist, der imstande ist, jede Ausgangsleitung (14) zu verschließen.

8. Architektur (100) zur Erzeugung eines elektrischen Zufallssignals, aufweisend:
- eine Vielzahl von Vorrichtungen (10) nach einem der Ansprüche 1 bis 7,
- eine Steuereinheit (24), die eine Klemme zwecks Einleitung eines zufallsbedingten Eingangssignals aufweist, wobei die Steuereinheit (24) imstande ist, den Magnetpartikelerzeuger (16) in Abhängigkeit von dem zufallsbedingten Eingangssignal zu steuern.

9. Architektur nach Anspruch 8, wobei sich das zufallsbedingte Eingangssignal in eine Anzahl vorher festgelegter Zustände und in Übergänge zwischen diesen Zuständen zerlegt, wobei die Steuereinheit (24) imstande ist, jeden Magnetpartikelerzeuger (16) in Abhängigkeit von den Zuständen und den Übergängen zu steuern.

10. Architektur nach Anspruch 8 oder 9, wobei die Architektur (100) zwei Vorrichtungen (10) aufweist, eine erste Vorrichtung (10) und eine zweite Vorrichtung (10), wobei sich das zufallsbedingte Eingangssignal in Übergänge zwischen zwei Zuständen, bezeichnet als niedriger Zustand und hoher Zustand, zerlegt, wobei ein hoher Übergang ein Übergang vom niedrigen Zustand zum hohen Zustand ist und ein niedriger Übergang ein Übergang vom hohen Zustand zum niedrigen Zustand ist, wobei die Steuereinheit (24) imstande ist, den ersten Magnetpartikelerzeuger (16) zu steuern, um ein Magnetpartikel bei Vorliegen eines hohen Übergangs zu erzeugen und die Steuereinheit (24) imstande ist, den zweiten Magnetpartikelerzeuger (16) zu steuern, um ein Magnetpartikel bei Vorliegen eines niedrigen Übergangs zu steuern.

## Claims

1. Device (10) for generating a random electrical signal, wherein the device (10) comprises:
- at least one input duct (12),
- at least one output duct (14),
- a generator (16) of magnetic particles capable of generating magnetic particles in the input duct (12),
- a diffusion chamber (18) connected to at least one input duct (12) and to at least one output duct (14), wherein the diffusion chamber (18) is able to diffuse the generated magnetic particles,
- a unit (20) for displacement of the generated magnetic particles towards the diffusion chamber (18), and
- a converter (22) that is designed to generate an electric signal proportional to a characteristic relating to the magnetic particles, wherein the characteristic is the density of magnetic particles in the diffusion chamber (18), or the passage of magnetic particles at a predetermined location of a output duct (14) connected to the diffusion chamber (18).

2. Device according to claim 1, wherein the generator (16) of magnetic particles is designed to generate skyrmions.

3. Device according to claim 1 or 2, wherein the device (10) further comprises a control unit (24) comprising an input terminal of a random input signal, wherein the control unit (24) is designed to control the generator (16) of magnetic particles according to the random input signal.

4. Device according to claim 3, wherein the control unit (24) is designed to control the generator (16) of magnetic particles to generate a magnetic particle in the presence of a predetermined transition between two predefined states.

5. Device according to any one of the claims 1 to 4, wherein the device (10) further comprises a thermostat (28) that is designed to control the temperature of the diffusion chamber (18).

6. Device according to any one of the claims 1 to 5, wherein at least either the geometry or the arrangement of the ducts (12, 14) connected to the diffusion chamber (18) is chosen to maximize the probability that the magnetic particles will be diffused.

7. Device according to any one of claims 1 to 6, wherein the diffusion chamber (18) comprises a shutter (30) that is designed to close each output duct (14).

8. Architecture (100) for generating a random electrical signal comprising:
- a plurality of devices (10) according to any one of the claims 1 to 7,
- a control unit (24) comprising an input terminal for the introduction of a random input signal, wherein the control unit (24) is able to control each magnetic particle generator (16) according to the random input signal.

9. Architecture according to claim 8, wherein the random input signal is broken down into a number of predefined states and transitions between these states, wherein the control unit is able to control each generator (16) of magnetic particles according to the states and transitions.

10. Architecture according to claim 8 or 9, wherein the architecture (100) comprises two devices (10), a first device (10) and a second device (10), wherein the random input signal breaks down into transitions between two states called low state and high state, wherein a high transition is a transition from the low state to the high state, and a low transition is a transition from the high state to the low state, wherein the control unit (24) is designed to control the first magnetic particle generator (16) to generate a magnetic particle in the presence of a high transition, while the control unit (24) is designed to control the second magnetic particle generator (16) to generate a magnetic particle in the presence of a low transition.
